# EUROPÄISCHE PATENTSCHRIFT

(11) **EP 3 063 309 B1**
(45) Veröffentlichungstag und Bekanntmachung des Hinweises auf die Patenterteilung: **12.10.2022**
(21) Anmeldenummer: 14795954.8
(22) Anmeldetag: 31.10.2014
(51) Int. Cl.: C23C 14/58, C23C 14/32, C23C 14/08

(54) **OXIDATIONSBARRIERESCHICHT**
OXIDATION BARRIER LAYER
COUCHE BARRIÈRE À L'OXYDATION

(30) Priorität: 03.11.2013 EP 13005182
(43) Veröffentlichungstag der Anmeldung: 07.09.2016
(73) Patentinhaber: Oerlikon Surface Solutions AG, Pfäffikon, 8808 Pfäffikon (CH)
(72) Erfinder: RAMM, Jürgen, CH-7304 Maienfeld (CH); SEIBERT, Florian, CH-9475 Sevelen (CH); WIDRIG, Beno, CH-7310 Bad Ragaz (CH); FOPP-SPORI, Doris, CH-7302 Landquart (CH)
(74) Vertreter: Misselhorn, Hein-Martin
(86) Internationale Anmeldenummer: PCT/EP2014/002924
(87) Internationale Veröffentlichungsnummer: WO 2015/062733

(56) Entgegenhaltungen:
- WO-A1-2014/111264
- US-A1- 2008 090 099
- LEVCHUK D ET AL: "Al-Cr-O thin films as an efficient hydrogen barrier", SURFACE AND COATINGS TECHNOLOGY, ELSEVIER, AMSTERDAM, NL, Bd. 202, Nr. 20, 15. Juli 2008 (2008-07-15), Seiten 5043-5047, XP022777556, ISSN: 0257-8972, DOI: 10.1016/J.SURFCOAT.2008.05.012 [gefunden am 2008-06-26]

## Beschreibung

Der Kontakt von metallischen und teilweise auch von keramischen Oberflächen mit Sauerstoff führt meist zu einer Oxidbildung an deren Oberfläche. Die Oxidation wird durch höhere Temperaturen gefördert und kann durch zusätzliche Reaktionen, beispielsweise durch das Vorhandensein weiterer Gase, noch verstärkt werden. In vielen Fällen sind die sich spontan an den Oberflächen bildende Oxide chemisch nicht stabil und verschlechtern deren mechanischen Eigenschaften. Häufig weisen diese Oxide eine Porosität oder chemische Instabilität auf, die eine weitere Sauerstoffdiffusion und die damit zusammenhängende Oxidation des darunter liegenden Metalls nicht verhindert. Aber selbst in Fällen, bei denen die gebildete Oxidschicht dicht gegen Sauerstoffdiffusion gebildet wird, führen zyklische thermische Belastungen zu einem aufbrechen der gebildeten Oxidschicht und zu Ablösung derselben vom Substrat. Resultat ist Materialverlust oder in anderen Worten: Verschleiss der metallischen Oberfläche. Die Erfindung bezieht sich auf eine dünne Oxidschicht, die mittels PVD auf der zu schützenden Substratoberfläche abgeschieden wird und die spontane Oxidation der metallischen Oberfläche verhindert und die auch unter zyklischer Temperaturbelastung gut anhaftend und mechanisch stabil ist.

### Stand der Technik

Aus DE69229513T2 ist bekannt, dass siliziumhaltige keramische Oberflächen durch eine Siliziumoxidschicht mit einem Aluminiumoxid als Zwischenschicht gegen Oxidation geschützt werden können. Dabei wird die Aluminiumoxid-Zwischenschicht als Barriere gegen Sauerstoffdiffusion benötigt.

In EP0880607B1 wird eine Oxidationsschutzschicht für hochschmelzende Materialien beschrieben, die aus Siliziden oder Aluminiden besteht, wobei zwischen der Oxidationsschutzschicht und dem hochschmelzendem Material notwendigerweise eine Reaktionssperrschicht vorgesehen ist. Die Reaktionssperrschicht ist eine Oxidschicht, vorzugsweise ein Hafnium oder Zirkonoxid.

US5741596A offenbart eine Oxidationsschutzschicht für metallische Substratoberflächen. Die Oxidationsschutzschicht setzt sich aus drei unterschiedlichen Schichten zusammen, wobei die erste Schicht im wesentlichen Mischungen aus Oxiden enthält, die zweite Schicht aus Aluminiumoxid und Siliziumkarbid besteht und die dritte oberflächennahe Schicht besteht aus Siliziumoxid und Beimengungen anderer Oxide und Siliziumkarbid. Neben der Oxidationsschutzwirkung soll diese Schicht auch höhere Emissivität und reduzierte katalytische Wirkung aufweisen.

In WO2005051866A1 wird eine Oxidationsbarriere für siliziumhaltige Keramiken offenbart, die in Gasturbinen verwendet werden und die im Betrieb heissen Gasen mit hohen Anteilen von Wasserdampf ausgesetzt sind. Ohne Oxidationsschutz kommt es zur Oxidbildung an der Oberfläche der Keramiken auf der Basis von Siliziumnitrid und Siliziumkarbid, was zu einem Materialverlust durch Erosion führt. Die Schutzschicht besteht aus einer Diffusionsbarriereschicht, einer weiteren Schicht als Oxidationsbarriere aus Scandiumdisilikat, einer weiteren Schicht, die vor Umwelteinflüsse schützt bestehend aus einem Tantaloxid und Scandiumsilikaten und -oxiden sowie schliesslich einer thermischen Schutzschicht, die stabilisiertes Zirkonoxid enthält. In dieser Anmeldung wird beschrieben, dass die die verschiedenen Schichten notwendig sind, zum einen um die Sauerstoffdiffusion in das Substrat zu verhindern und andererseits um die Formierung eines mechanisch instabilen Oxids an der Oberfläche zu vermeiden. Es wird auch auf die Problematik hingewiesen, dass beispielsweise ein dünnes Oxid aus Si02 eine gute Diffusionsbarriere bildet, aber es muss dünn genug sein, damit es nicht zu Rissen in dieser Schicht kommt. Im Prinzip schildert dieses Patent sehr anschaulich die komplizierte Problematik, um eine Oxidationsbarriereschicht zu optimieren und die komplizierten Zusammenhänge, die bei der Anpassung von mechanischen Eigenschaften der Schutzschichten untereinander und ihrer unterschiedlichen Oxidationsfähigkeit beachtet werden müssen, damit eine wirksame und stabile Oxidationsschutzschicht erzielt werden kann.

Levchuck D et al: "Al-Cr-O thin films as an efficient hydrogen barriere", Surface and Coatings Technology, Slsevier, Amstadam, NL, Bd. 202, Nr. 20, 15. Juli 2008 (2008-07-15), Seiten 5043-5047, XP022777556, ISSN: 0257-8972 beschreiben, dass eine Al-Cr-O-Beschichtung auf einem EUROFER-Substrat aufbringbar ist. Diese Druckschrift lehrt eine Wasserstoffbarriereschicht, und lehrt insbesondere, dass dünne Schichten zur Verhinderung von Wasserstoffpermeation verwendbar sind.

Die US 2008/090099 A1 offenbart ein Schichtsystem auf irgendwelchen Werkstücken, ohne dass die Werkstücke bezüglich des Materials vertiefend beschrieben sind. Beispielsweise kann auf dem Werkstück eine Haftschicht aus AICrN abgeschieden sein, und darauf eine als Top-Schicht abgeschiedene Hartmetallbeschichtung aus AlCrON, was beispielsweise das Schichtsystem bilden könnte.

### Nachteile des Stands der Technik

- Design der Oxidationsbarriereschicht hängt stark vom zu schützenden Material ab
- Meist bedingt die Oxidationsbarriereschicht noch weitere Schichten, die zur Anpassung dienen
- Häufig übernimmt die Oxidationsbarriere zwar die Barriereeigenschaften, zeigt aber nicht genug mechanische Stabilität und thermische Barrierewirkung
- Die Herstellungsmethoden sind entsprechend der Komplexität des Schichtsystems, das die Oxidationsbarriere enthält, entsprechend komplex und wirtschaftlich aufwendig.

### Ziel der Erfindung

Ziel der Erfindung ist es, eine gegenüber dem Stand der Technik stark vereinfachte Oxidationsbarriere in Form einer dünnen Schicht zu finden, die sowohl metallische wie auch keramische Oberflächen vor einer Oxidation und den damit zusammenhängenden Verschleiss schützt. Die Oxidationsbarriere soll folgenden Anforderungen genügen:
1. Chemisch stabile Verbindung in sauerstoffhaltiger Atmosphäre für sehr hohe Umgebungstemperaturen, also über 800°C, bevorzugt über 1000°C und besonders bevorzugt über 1200°C.
2. Barriereeigenschaften bezüglich des Sauerstofftransportes, um die Oxidation tieferliegender Substratregionen zu vermeiden, damit verhindert wird, dass es zu Dichteänderungen in tieferliegenden Regionen des Substrates oder Schichtpaketes kommt, was ein daraus resultierendes mechanisches Versagen von Schichtpaket oder Substratoberfläche zur Folge haben könnte.
3. Mechanisch stabile chemische Verbindung in Schichtform, die neben hoher Härte bei hohen Temperaturen auch gute Verschleisseigenschaften aufweist.
4. Gute Anpassbarkeit der Oxidationsbarriereschicht an das Substrat oder an eventuell andere Schutzschichten im Hinblick auf Stabilität der Schicht oder des Schichtpaketes bezüglich thermischer Zyklen.
5. Wirtschaftliche Herstellungsmethode der Oxidationsbarriereschicht, geeignet für eine grosse Zahl von Substratmaterialien, d.h. beispielsweise, dass die Verfahrenstemperaturen dem Substratmaterial angepasst werden können.
6. Herstellungsmethode soll gut kombinierbar sei mit der Herstellung anderer Materialien, besonders in Form von dünnen Schichten.

### Beschreibung der zu lösenden Problematik

Allgemein ist der Schutz von metallischen und keramischen Oberflächen ein wichtiges Anwendungsgebiet von Oxidationsbarriereschichten. Von besonderer Bedeutung ist dieser aber für Materialien, die bei hohen Temperaturen eingesetzt werden. Bei den metallischen Substraten sind das unter anderem Hochtemperaturlegierungen wie Ni-Basislegierungen, intermetallische Verbindungen (z. B. Laves Phasen oder einige Ni-, Fe- und Ti-Aluminide) sowie einige Mischkristallverbindungen. Solche Verbindungen wurden und werden entwickelt, um beispielsweise hohe mechanische Festigkeiten bei hohen Temperaturen zu gewährleisten, also beispielsweise die Fliessgrenzen des Materials zu erhöhen.

Bei den Hochtemperaturlegierungen werden solche Verbesserungen bezüglich der mechanischen Eigenschaften durch Zusatz geeigneter Legierungs- und Dotierelemente, die zur Verfestigung des Ausgangsmaterials beitragen, realisiert. Diese Legierungselemente und Dotierungen ermöglichen beispielsweise bei hohen Temperauren die Bildung intermetallischer Verbindungen aus der Legierung heraus oder bestimmte Mischkristallbildungen, die die Temperaturbeständigkeit erhöhen. Diese Vorgänge sind dem Fachmann unter den Begriffen Mischkristall-, Ausscheidungs- und Dispersionshärtung bekannt. Neben dem Ziel, bessere mechanische Eigenschaften bei hohen Temperaturen zu erreichen, gibt es aber auch noch einen anderen Grund, dass diese Legierungselemente oder Dotierungen den Basiselementen beigegeben werden. Das ist der Wunsch, die Oxidationsfestigkeit des metallischen Materials zu erhöhen. Deshalb geschieht das Legieren mit beispielsweise Al, Si, Cr oder seltenen Erden auch unter dem Aspekt, dass sich von selbst ein Oxid dieser Elemente bei den hohen Temperaturen bildet und dieses dann als Schutzoxid wirkt, um das übrige Grundmaterial vor weiterer Oxidation zu schützen. Natürlich wird dabei angestrebt, dass sich möglichst nur das stabile oder ein stabiles Oxid des Grundmaterials an der Oberfläche bildet. Es wird also eine selektive Oxidation der Materialoberfläche für das stabilste Oxid angestrebt. Die Bildung des Oberflächenoxids (sog. "scaling") hängt von vielen Faktoren ab: Temperatur, Umgebungsbedingungen, dem aktuellen Bindungszustand der Elemente (ob legiert, als intermetallische Verbindung oder Mischkristall), von der chemischen Zusammensetzung der metallischen Oberfläche. Es ist also nicht verwunderlich, dass eine Voraussage der Schutzwirkung eines solchen Oxids schwierig ist für einen spezifischen Anwendungsbereich und es ist kaum zu erwarten, dass ein solches Oxid breite Anwendungsbereiche abdeckt. Allgemein lässt sich sagen, dass sich mit dem Legieren oder Dotieren und der daraus resultierenden Komplexität der Zusammensetzung, auch das Verhalten unter hohen Temperaturen ändert. Abhängig von den Bedingungen, kann die Oxidation der Legierungen selektiv verlaufen, es kann zur Formierung komplexer Oxide kommen und/oder zu interner Oxidation über Diffusionsprozesse. All diese Prozesse verlaufen bei hohen Temperaturen rascher und sind im wesentlich nicht linear, d.h. schwer aufeinander abstimmbar. Hinzu kommt noch die Schwierigkeit, die gute Haftung eines solchen, auf "natürliche" weise gewachsenen Oxids auf der metallischen Unterlage zu garantieren. Das ist eine jedoch eine notwendige Bedingung, um die Erosion des Oberflächenoxids zu vermeiden, falls dieses mechanischen Beanspruchungen ausgesetzt wird. Ein Konzept, diese Haftung zu verbessern besteht darin, dass das Hochtemperaturmaterial mit seltenen Erden dotiert wird (Y, Ce La). Das erhöht natürlich erneut die Komplexität der Oxidationsprozess und Oxidformierung bei den Vorgängen unter hohen Temperaturen.

Trotz dieser Problematik haben sich die Hochtemperaturlegierungen bereits in vielen Bereichen der Technik durchgesetzt. Als Beispiel hierfür sollen die Ni-Basislegierungen genannt werden, die unter Handelsnamen wie Nimonic, Inconel, Hasteloy, um nur einige zu nennen, bekannt sind. Beispielsweise findet der hochwarmfeste Werkstoff NiCo20Cr15Mo6AlTi (2.4634) bei Gasturbinenschaufeln Anwendung und die Superlegierung NiCr20TiAl (Nimonic80A, 2.4631) wird bei Auslassventilen für Großdieselmotoren verwendet.

Ähnlich wie bei den Legierungen, können auch die intermetallischen Verbindungen in oxidativer Umgebung ein Schutzoxid bilden. Die Bedingungen, dass eine intermetallische Verbindung ein effektives Schutzoxid bildet, werden ausführlich in H.J. Grabke und M. Schütze "Oxidation of Intermetallics", Wiley-VCH, Weinheim, 1998, Seiten 15 und folgende, geschildert. Die selektive Oxidation, um eine solche handelt es sich bei dem Oxidwachstum auf intermetallischen Verbindungen, wird einesteils bestimmt durch die Wachstumsraten des jeweiligen Oxids. Deshalb bieten nur Oxide mit geringen Wachstumsraten auch ausreichend Schutz vor Oxidation. Aluminiumoxid und Siliziumoxid weisen beispielsweise geringere Oxidwachstumsraten auf als etwa Titanoxid oder Chromoxid oder Nickeloxid. Allerdings muss die Oxidation zu einer kontinuierlichen Schicht auf dem Substrat führen, d.h. die Zusammensetzung der intermetallischen Verbindung muss so gewählt sein, dass der Anteil beispielsweise des Aluminiums gross genug ist, um trotz der geringen Oxidwachstumsrate eine geschlossene Schicht zu garantieren. Bei den intermetallischen Verbindungen auf Ni-Al-Basis kann dieses Schutzoxid bevorzugt aus Aluminiumoxid bestehen. Allerdings hängt die Bildung einer solchen Schutzschicht aus Aluminiumoxid noch von zusätzlichen Parametern ab, beispielsweise von der chemischen Zusammensetzung. Während beispielsweise NiAl über den ganzen Temperaturbereich eine Aluminiumoxidschutzschicht bildet (nach Doychak zitiert in Grabke, Seite 19), trifft das für das Ni3Al nur für Temperaturen oberhalb 1200°C zu. Der Prozess der Oxidation ist unterschiedlich für die verschiedenen intermetallischen Verbindungen, d.h. dass zwar für NiAl eine geschlossene Aluminiumoxidschicht an der Oberfläche gebildet werden kann, dass aber beispielsweise Ti3Al wesentlich schneller erodiert wird, weil keine reine Aluminiumoxidschutzschicht gebildet wird, sondern eine Mischung aus Titandioxid (Rutile) und Aluminiumoxid.

Ähnlich wie bei den Hochtemperaturlegierungen, muss, um einen bleibenden Schutz durch etwa ein Aluminiumoxid zu erzielen, auch gefordert werden, dass dieses Oxid eine gute Haftung aufweist, vor allem wenn es, wie es in vielen Anwendungen der Fall ist, Temperaturzyklen ausgesetzt ist. Die Haftung des Schutzoxides auf dem Substrat muss in solchen Fällen sogar besonders gut sein. Voraussetzung dafür sind angepasste Temperaturkoeffizienten zwischen Schutzoxid und Substrat. Eine solche Anpassung ist aber in vielen Fällen schwer zu beeinflussen, da ja bei den intermetallischen Verbindungen das Schutzoxid über die selektive Oxidation gebildet wird und diese somit durch die vorgegebene chemische Zusammensetzung der intermetallischen Verbindung vorgegeben ist. Es kann deshalb gar nicht erwartet werden, dass bei der durch die intermetallische Verbindung vorgegebenen chemischen Zusammensetzung die Schutzwirkung des gebildeten Oxids optimal ist. Meist kommt es sogar zu keinem ausreichenden Oxidationsschutz, was eine fortlaufende Erosion des Grundmaterials zur Folge hat. Eine weitere Problematik besteht darin, dass der Oxidationsvorgang des Basismaterials (Substrates) von der Temperatur und den Umgebungsbedingungen abhängig ist. Es kann durchaus sein, dass eine Barrierewirkung für Bereiche zwischen 600 und 800°C erreicht wird, dass aber diese Schutzwirkung nicht mehr existiert für Temperaturbereiche über 1000°C, da die gebildeten Oxide entweder nicht mehr stabil sind, oder aber Diffusionsvorgänge durch das Oxid ins Substratmaterial zu Dichteänderungen und damit zur mechanischen Schwächung der Substratoberfläche führen.

Für Mischkristallverbindungen gilt ganz analog, was schon oben für die Hochtemperaturlegierungen und intermetallischen Verbindungen gesagt wurde.

Zwei Beispiele sollen die zu lösende Problematik deutlicher illustrieren. An ihnen soll gezeigt werden, welchen Einschränkungen die Schutzoxidbildung, die auf der Basis der selektiven Oxidation, also dem spontanen Wachstum des Oxides auf dem Grundmaterial beruht, unterliegt.

### 1. Beispiel: Oxidation einer Stahloberfläche

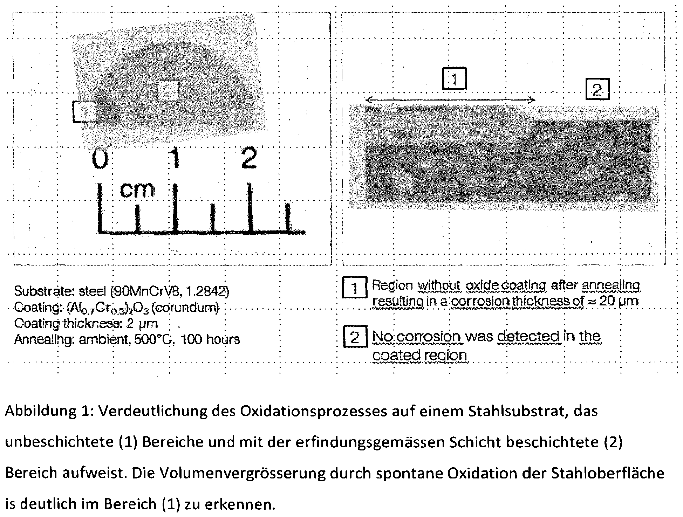

In Abb. 1 ist die Oxidbildung auf einer Stahloberfläche bei Auslagerung an Atmosphäre demonstriert. Diese Probe wurde teilweise (Bereich 2) mit einer erfindungsgemässen Schicht abgedeckt, während andere Bereiche (1) der Probe unbeschichtet blieben. Anschliessend wurde die Probe auf 500°C in einem Ofen in Umgebungsatmosphäre aufgeheizt und für 100 h auf dieser Temperatur belassen. Danach wurde ein Querschliff von der Probe angefertigt, um den Bereich im Übergang unbeschichtet(1)/beschichtet(2) im Lichtmikroskop zu untersuchen. Die Mikroskopaufnahme zeigt, dass während der 100 h im unbeschichteten Bereich 1 ein Oxid (Rost) von ca. 20 µm Dicke gewachsen ist, während auf dem beschichteten Bereich (2), der mit einer erfindungsgemässen Schicht von ca. 2 µm Dicke belegt ist, keine Oberflächenveränderung zu sehen ist, d.h. die erfindungsgemässe Schicht schützt die Stahloberfläche wirkungsvoll gegen Oxidation. Auf der mikroskopischen Aufnahme kann man auch noch anderes erkennen. Zum einen ist das Oxidwachstum mit Volumenvergrösserung verbunden. Das Oxid wächst ins Substrat hinein und aus dem Substrat heraus, d.h. das einmal gewachsenen Oxid verhindern nicht ein weiteres eindringen des Sauerstoffs in das Substrat und die dementsprechende fortlaufende Oxidation unter der sich einmal gebildeten Oxidschicht. Das spontan gebildete Oxid auf dem Stahlsubstrate ist also für diesen Stahl kein Oxidationsschutz. Der beschichtete Bereich (2) verhält sich ganz anders. Einesteils ist dort kein Oxidwachstum sichtbar (auch nicht bei weiterer optischer Vergrösserung) und andrerseits gibt es auch keine Anzeichen für eine Diffusion des Sauerstoffs durch die erfindungsgemässe Schicht hindurch. Der Bereich (2) erfüllt also wichtige Forderungen an eine gute Oxidationsbarriere:
- Kein Oxidwachstum und die damit verbundenen Änderungen im Materialvolumen
- Verhinderung des Eindringens von Sauerstoff in das Substrat und deshalb keine Oxidbildung unterhalb der erfindungsgemässen Schicht.

### 2. Beispiel: Das Verhalten von Al-Hf intermetallischen Verbindungen beim Aufheizen an Normalatmosphäre bis 1290°C

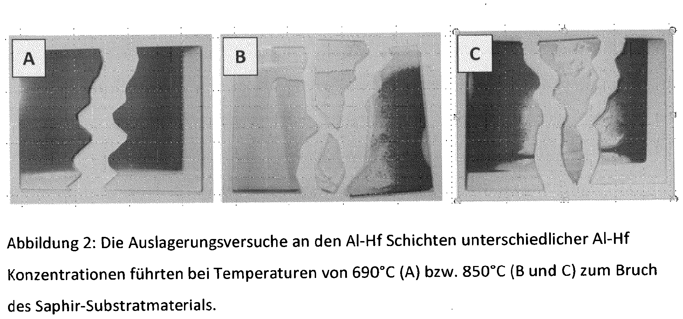

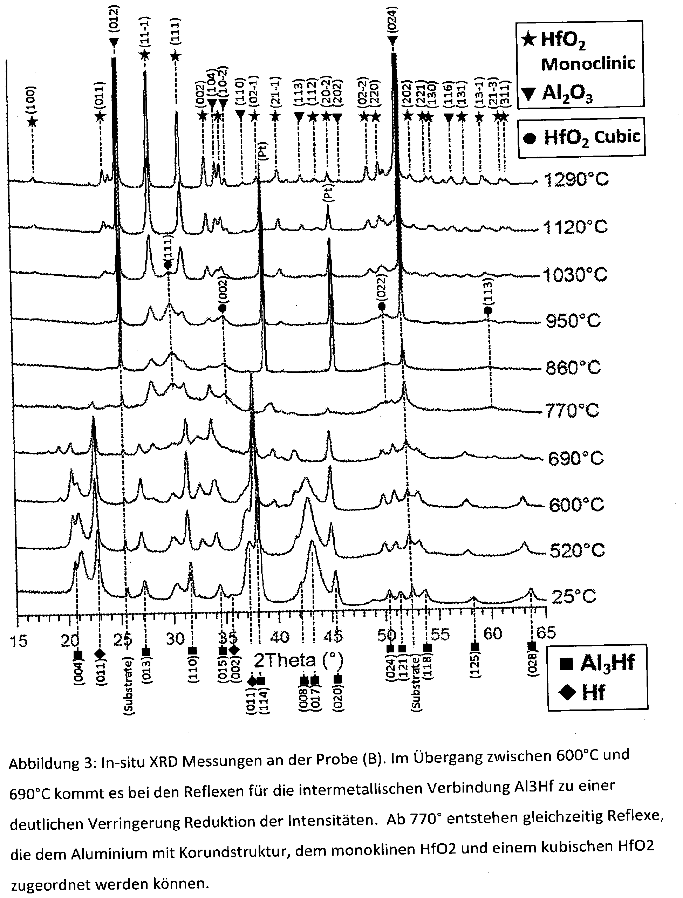

Es wurde eine Al-Hf Schicht mittels kathodischer Funkenverdampfung synthetisiert. Die Analyse der Schicht (A) mittels EDX ergab eine chemische Zusammensetzung von 37 at.% Al und 63 at.% Hf. Der Gehalt an Sauerstoff wurde zu einigen Prozenten abgeschätzt, die lediglich einer Oxidation zugeschrieben werden, die dadurch zustande kommt, dass die Schichtoberfläche Normalumgebung ausgesetzt wurde (nachgeprüft mittels RBS). Die Analyse der kristallinen Phasen von (A) wurde mittels XRD durchgeführt und ergab, dass die Schicht aus der Hf Phase und den intermetallischen Phasen von vor allem AI3Hf und, in geringerem Umfang, Al2Hf besteht. Andere amorphe Phasen können nicht ausgeschlossen werden, sind aber mit dieser Methode nicht festzustellen. Die Schicht wurde auf einem Saphir-Substrat abgeschieden, um eine thermisch stabile Unterlage für die Ausheizversuche zu gewährleisten. Die Auslagerungsversuche wurden an Atmosphäre vorgenommen und es sollten Temperaturen im Bereich von Raumtemperatur (RT) bis 1200°C untersucht werden. Es zeigte sich aber, dass das Substrate bei einer Temperatur von 690°C auseinanderbrach (Abb. 2). Ausheizversuche wurden auch für die unterschiedlichen Schichtkompositionen von Al0.59Hf0.41 (B) und Al0.67Hf0.33 (C) durchgeführt, um zu testen, ob eventuell höherer Al-Gehalt das Problem der mechanischen Instabilität lösen könnte. Auch für diese Schichtkompositionen wurden die kristallinen Phasen durch XRD bestimmt. Neben dem metallischen Hf wurden wieder die Phasen Al3Hf und Al2 Hf gefunden. Da die Konzentration des Al in den Schichten erhöht wurde, verschob sich der Phasenanteil entsprechend zu den Al-reicheren Al3Hf. Trotz des höheren AI-Anteils entsprachen die Auslagerungsversuche nicht den Erwartungen und es ergab sich ein qualitativ ähnliches Resultat wie bei der ersten Probe. Bei einer Temperatur von ca. 850°C zerbrachen in beiden Fällen die Saphir-Substrate (Abb. 2). Die Vermutung lag nahe, dass das Oxidwachstums auf oder in den intermetallischen Verbindungen und die damit zusammenhängenden Volumenänderungen zum Bruch im Substrat führen. Zur Bestätigung dieser Vermutung wurden nun die Oxidationsprozesse an den Al-Hf-Schichten mittels in-situ XRD Messungen näher untersucht (Abb. 3). Die hier gezeigten Versuche wurden an der Al0.59Hf0.41 Schicht (B) vorgenommen. Die auf dem Saphir-Substrat bei ca. 550°C Substrattemperatur abgeschiedene Schicht, zeigt neben den charakteristischen Saphir-Substratreflexen (in der Abbildung als Substrat gekennzeichnet) bei 2Theta von ca. 25.7° und ca. 52.6°, lediglich weitere Reflexe der intermetallischen Verbindungen Al3Hf und Al2Hf und dem metallischen Hf. Die Peaks des Al2Hf sind sehr schwach und wurden nicht in der Abbildung bezeichnet, um die Übersichtlichkeit zu wahren. Diese Schicht wurde nun an Atmosphäre aufgeheizt in Schritten von 5°C/min und dann wurde die XRD Analyse an den bezeichneten Temperaturen vorgenommen. Dieser Messvorgang beanspruchte jeweils 15 min. An den Ergebnissen kann man folgendes ablesen. Im Übergang zwischen 600°C und 690°C kommt es bei den Reflexen für die intermetallischen Verbindung AI3Hf zu einer deutlichen Verringerung Reduktion der Intensitäten. Ab 770° entstehen gleichzeitig Reflexe, die dem Aluminium mit Korundstruktur, dem monoklinen HfO2 und einem kubischen Hf02 zugeordnet werden können. Mit dem entstehen dieser Phasen verschwindet zunehmend der Hf Reflex. Diese Messresultate unterstützen also die Oxidation des Hf bzw. der intermetallischen Verbindungen und zwar über die Bildung einer kubischen Phase des Hf02 vor. Während die Intensitäten der Reflexe für das Aluminiumoxids und das monokline HfO2 sich mit der Temperatur erhöhen oder stabil bleiben, verschwinden die Reflexe des kubischen HfO2 bei etwa 1120°C. Aus diesen Messungen kann man folgendes ablesen:
- Eine deutliche Oxidation der Schicht beginnt zwischen 600°C und 700°C. Dieser Oxidationsvorgang ändert die Schicht bis ca. 1120°C. Das Versagen des Substrates wie es in Abb. 2 dargestellt ist, fällt also in diesen Bereich und kann mit dem Oxidwachstum und den damit zusammenhängenden Volumenänderungen erklärt werden.
- Das Verschwinden der Reflexe der intermetallischen Verbindungen und des Hf zeigt, dass die Oxidation in die Tiefe geht, d.h. dass die gebildeten Oxide keine Diffusionsbarriere bezüglich Sauerstoff bilden, vor allem nicht im tieferen Temperaturbereich.
- Es erfolgt eine schrittweise Oxidation, über die Bildung wahrscheinlich einer kubischen Phase des höherschmelzenden metallischen Elementes im Materialsystem, nämlich Hf.
- Es entstehen, von der Übergangsphase abgesehen, zwei Oxidphasen mit entsprechend unterschiedlichen Eigenschaften bezüglich Dichte und Stabilität, die demnach auch unterschiedliche mechanische Festigkeit aufweisen.

Dieses Ergebnis illustriert die eingangs geschilderte Problematik und unterstreicht noch einmal, wie wichtig es ist, den Oxidationsprozess an der Oberfläche von intermetallischen Verbindungen, Mischkristallen und Legierungen zu kontrollieren, besonders dann, falls die Oxide zusätzlich zu den anwendungsspezifischen Verschleissprozessen auch noch Temperaturzyklen mit den dabei auftretenden mechanischen Beanspruchungen ausgesetzt sind. Die Kontrolle schliesst sowohl das Vermeiden von Oxidation an der Oberfläche der zu schützenden Substrate ein und in diesem Zusammenhang auch das verhindern der Sauerstoffdiffusion in das Substrat hinein.

Ein erstes Ziel dieser Erfindung ist es, eine Schutzschicht auf einer Hochtemperaturlegierung, intermetallischen Verbindung oder Mischkristallverbindung abzuscheiden, die in oxidierender Umgebung und bei hohen Temperaturen mechanisch stabil bleibt und die Sauerstoffdiffusion zum Substrat hin stak reduziert bzw. verhindert.

In dem nächsten Beispiel wird ein erster Ansatz zur Lösung gezeigt, der spezifisch auf das Substratmaterial bezogen ist und bereits in einigen Fällen das Problem lösen kann

### 2. Beispiel: Beschichten mit einer materialverwandten Oxidschicht

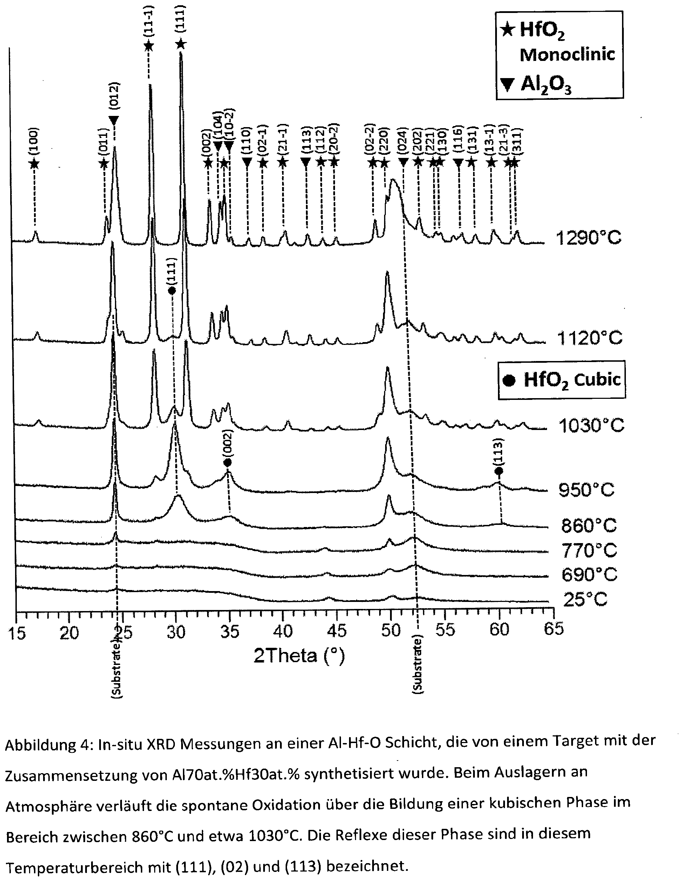

Nachdem gezeigt wurde, dass eine spontane und selektive Oxidation an den Oberflächen von Legierungen, intermetallischen Verbindungen und Mischkristallen zu deren mechanischen Zerstörung führen kann, wurden in einem weiteren Schritt Schichten untersucht, die bereits als Oxid abgeschieden wurden. Da es bei der Problemstellung darum geht, eine Legierung oder intermetallische Verbindung bestimmter chemischer Zusammensetzung zu schützen, wurde auch für das zu untersuchende Schutzoxid das materialverwandte System Al-Hf gewählt, um damit das entsprechende Oxid zu synthetisieren. Zur Schichtherstellung wurde wieder das Verfahren der kathodischen Funkenverdampfung benutzt, wobei dieses Mal die Al-Hf Targets im Sauerstoffreaktivgas betrieben wurden, bei einer Substrattemperatur während der Beschichtung von 550°C. Untersucht wurde eine Al-Hf-O Schicht, die von einem Target mit der Zusammensetzung von Al70at.%Hf30at.% erhalten wurde. Die synthetisierten Schichten wurden auf ihre chemische Zusammensetzung hin untersucht und es wurde gefunden, dass es sich um Oxide handelt, die ähnliche Zusammensetzung der metallischen Anteile aufweisen wie die verwendete Targetzusammensetzung. Der Sauerstoffgehalt dieser Schichten entsprach in etwa dem einer vollständigen Oxidation, falls man die Oxidphasen berücksichtigt, die sich nach dem Auslagern auch ausbildeten. An diesen Oxidschichten wurden wieder XRD Untersuchungen während des Aufheizens an Atmosphäre durchgeführt. In Abb. 4 sind die XRD Spektren als Funktion der Temperatur angegeben. Folgendes kann man aus diesen Messungen ablesen. Bei Raumtemperatur sieht man bei einem Winkel von 2Theta von etwa 50.5° einen Reflex, den man dem monoklinen Hf02 zuordnen kann. Weiter ist ein Hintergrundsignal im Bereich von 2Theta kleiner 35° zu sehen. Bei 770°erhöht sich die Kristallinität des HfO2 und es erscheinen Peaks für das Aluminiumoxid (Korundstruktur), wobei nicht klar zugeordnet werden kann, ob diese dem Saphir-Substrat oder der Schicht zuzuordnen sind. Bei 860°C erhöht sich die Kristallinität sowohl vom Korund wie vom HfO2 und es muss angenommen werden, dass das Peak bei 2Theta von 24.5° doch der Schicht zuzuordnen ist. Zusätzlich erscheinen (002) und (113) Reflexe, die einer kubischen Phase des Hf02 zugeordnet werden können (in Abbildung bezeichnet). Diese gehen dann allerdings bei 1030°C über in die monokline HfO2 Phase. Bei dieser Temperatur sind die Reflexe für Aluminiumoxid (Korund) und monoklines Hf02 bereits deutlich sichtbar und es kommt bei weiterer Temperaturerhöhung bis 1290°C lediglich zu einer verbesserten Kristallinität dieser Phasen.

Die Saphirsubstrate mit diesen Oxidschichten zeigten keine Neigung zum Brechen, d.h. der Einbau des Sauerstoffs in die intermetallische Al-Hf Schicht oder mit anderen Worten, die Synthetisierung einer Schicht aus Al-Hf Oxid an der Substratoberfläche entschärfte das Problem der mechanischen Instabilität. Dem Fachmann ist es einleuchtend, dass für praktisch alle Hochtemperaturlegierungen und intermetallische Verbindungen materialverwandte Oxide mittels reaktiver kathodischer Funkenverdampfung- hergestellt werden können. Damit kann das Problem der mechanischen Instabilitäten, die durch das Oxidwachstum an der Substratoberfläche entstehen, vermieden oder zumindest entschärft werden. Die Versuche wurden mit vergleichbaren Resultaten auch an einer Reihe von anderen Materialien durchgeführt. In allen Fällen konnten deutliche Verbesserungen bezüglich der mechanischen Stabilität beobachtet werden, auch deshalb weil die Haftung der Oxidschichten auf den jeweiligen Grundmaterialien gut war. Um Beispiele zu nennen, wurden Legierungen wie Inconel mit einer Ni-Cr-0 Schicht beschichtet oder intermetallische Verbindungen auf der Basis von Al-Ni, Al-Fe und Al-Ti. Ein weiterer Vorteil dieser Oxidbeschichtung ist die freie Wählbarkeit in der Zusammensetzung der metallischen Komponenten. Diese ermöglicht es in einem gewissen Umfang den Anteil des metallischen Elements, von dem eine stabilere Oxidphase erwartet wird, zu erhöhen, um damit den Anteil dieser Oxidphase in der Schicht zu erhöhen und bessere Oxidbarriereeigenschaften zu erzielen und trotzdem im materialverwandtem System zu bleiben. Eine solche Lösung kann auch wirtschaftliche Vorteile haben, beispielweise wenn intermetallische dünne Schichten abgeschieden werden und dann für die Synthese der Oxidschutzschicht die gleichen Targets benutzt werden können.

Zusammenfassend kann man sagen, dass Oxidschichten, die in ihren metallischen Komponenten materialverwandt sind mit den metallischen Komponenten an der Oberfläche des Substrates eine **erste Lösung** darstellen.

Im Sinne der vorliegenden Erfindung wird ein Oxid als materialverwandt zu einer unbeschichteten Oberfläche eines Werkstückes bezeichnet, indem es die gleichen metallischen Komponenten aufweist, die auch in der unbeschichteten Oberfläche des Werkstückes zu finden sind. Allerdings können die metallischen Anteile im materialverwandten Oxid in anderen Konzentrationen vorliegen, als es in der unbeschichteten Oberfläche des Werkstückes der Fall ist.

Obwohl dieser Lösungsansatz zu einer beträchtlichen Verbesserung der mechanischen Stabilität und der Barriereeigenschaften beiträgt, was auch der Grund ist, dass er einen ersten Aspekt der Erfindung ausmacht, enthält er einen verbesserungswürdigen Aspekt. Die Oxidschichten basieren im Allgemeinen auf einer Oxidschicht, die mehrphasig ist. Das ist in den meisten Fällen nicht zu vermeiden, falls man die Oxidschicht mit den gleichen metallischen Komponenten aufbauen möchte, aus denen auch das Grundmaterial besteht. Und das macht auch durchaus Sinn, wenn man Diffusionsprozesse reduzieren möchte, um damit die mechanische Stabilität einer Substratoberfläche zu verbessern. Die mehrphasigen Oxide bergen aber unter Extrembedingungen (Temperaturzyklen, hohe Temperaturen) immer noch die Gefahr, dass es durch das Auskristallisieren (Bildung grösserer Kristallite) und durch ein eventuelles Nachoxidieren geringer metallischer Schichtanteile und die damit verbundenen Dichteänderungen zu Rissen in der Schicht kommen kann und dadurch die mechanischen und Oxidbarriereeigenschaften verschlechtert werden.

Ein weiteres Ziel dieser Erfindung ist es, eine harte temperaturbeständige Schicht auf einer metallischen Oberfläche, insbesondere auf der Oberfläche von Legierungen, intermetallischen Verbindungen und Mischkristallen aufzubringen, die den Sauerstofftransport zu der darunterliegenden Oberfläche verhindert.

Nur dichte Schichten können diese Anforderungen erfüllen. Erfindungsgemäss kann dies dadurch erreicht werden, dass eine sich bezüglich der Sauerstoffdiffusion selbst schliessende Schicht zu gefertigt wird, so dass unter Sauerstoffeinwirkung, beispielsweise die Diffusion des Sauerstoffs entlang der Korngrenzen unterbunden wird und dass eventuelle metallische Partikel aus einem nicht vollständig durchoxidierendem Material, wie beispielsweise metallische Spritzer in einer oxidischen Schicht, sich selbst gegenüber Sauerstofftransport abdichten.

Die Schicht kann erfindungsgemäss "angepasst" auf die jeweilige Substratoberfläche aufgebracht werden, d.h. mit exzellenter Haftung bei Raumtemperatur sowie bei den hohen Temperaturen, die im Betrieb erreicht.

Ein weiteres Ziel dieser Erfindung ist es, dass sich das Material aus dem die Oxidationsschutzschicht besteht, sich nur unwesentlich ändert, wenn es hohen Temperaturen ausgesetzt wird, d.h. dass es zu keinen oder nur geringen Änderungen in der Dichte kommt, falls es thermischen Zyklen ausgesetzt wird und dass es zu keinen oder nur unwesentlichen Phasentrennungen durch das Aufheizen kommt.

Ein weiteres Ziel der Erfindung ist es, dass die Oxidationsschutzschicht ein "scaling", d.h. ein selbständiges selektives Oxidwachstum auf intermetallischen Verbindungen, verhindert.

Die Oxidationsbarriereschicht kann erfindungsgemäss so aufgebracht werden, dass sie selbst ein "scaling" bildet, welches die gleiche Kristallstruktur aufweist wie die Oxidationsbarriereschicht und lediglich eine geänderte chemische Zusammensetzung hat.

Gelöst werden die Aufgaben gemäss einer Ausführungsform der vorliegenden Erfindung dadurch, dass Al-Cr-O Schichten in vorwiegend Korundstruktur auf den oben genannten Oberflächen mittels eines PVD Verfahrens, bevorzugt eines Verfahrens der reaktiven kathodischen Funkenverdampfung, abgeschieden werden.

Die Beschichtung von Substraten mit Al-Cr-O Schichten mittels reaktiver kathodischer Funkenverdampfung ist bekannt (siehe z.B. WO2008/043606). Es ist auch bekannt, dass die Gitterparameter dieser Mischkristallstruktur im Wesentlichen stabil sind bis 1100°C, d.h. dass diese Mischkristallschicht auch für hohe Temperaturen bezüglich ihrer Kristallstruktur im Wesentlichen stabil bleibt. In der WO2008/043606 ist auch beschrieben, dass die Al-Cr-O Schicht der unter ihr liegenden Schicht aus TiCN thermische und oxidative Beständigkeit verleiht. Zugeschrieben wurde das einer Reaktionszone, die sich auf der Al50Cr500 3 Schicht nach dem Auslagern an Atmosphäre bei 1000°C bildet und für die eine Dicke von 32 nm abgeschätzt wurde. Inwieweit eine solche Oxidschicht nur Schichten gegen Oxidation schützt, die **nur eine** metallische Komponente enthalten und deren Oberfläche sich unter Vakuumbedingungen gebildet hat (also Oberflächen von Vollmaterialien), die vorher der Atmosphäre ausgesetzt waren, wurde nicht untersucht.

In einem ersten Versuch wurden deshalb mit dem Verfahren der reaktiven kathodischen Funkenverdampfung Oberflächenbereiche von Proben aus Kaltarbeitsstahl (90MnCrV8, 1.2842) mit Al-Cr-O beschichtet und mit den unbeschichteten Bereichen auf der gleichen Probe nach einer Auslagerung an Atmosphäre bei 500°C und für 100h verglichen. Die Ergebnisse wurden bereits weiter oben diskutiert und es war überraschend, dass der beschichtete Bereich des Stahlsubstrats sehr effektiv gegen ein Oxidwachstum, demzufolge auch gegen Sauerstoffdiffusion, geschützt werden konnte. Trotz der vergleichsweise geringen Auslagerungstemperatur (bedingt durch das Stahlmaterial) sieht man den deutlichen Effekt des Al-Cr-O Schutzoxides. Dieser Effekt besteht, obwohl sich in diesem Stahlmaterial neben Fe auch noch andere Elemente wie Cr, C, Si, Mn, V befinden. Deutlich wird an diesem Beispiel aber auch, dass die auf dem unbeschichteten Bereichen gebildeten Oxide keinen Schutz gegenüber Oxidation bieten. Es blieb ausserdem unklar, bis zu welcher Temperatur die Schutzwirkung des Al-Cr-O bestehen bleibt.

Deshalb wurden Auslagerungsexperimente an intermetallischen Verbindungen und an Hochtemperaturlegierungen vorgenommen. Die Problematik der Oxidation dieser Materialien, nämlich das selektive Oxidwachstum, wurde bereits geschildert. Als eine erste Lösung wurde die Beschichtung mit einer Oxidschicht basierend auf den metallischen Elementen vorgeschlagen. Prozesstechnisch hat eine solche Lösung viele Vorteile. Als Nachteil wurde aber die Tatsache erkannt, dass mehrphasige Oxide in bestimmten Temperaturbereichen immer noch zu mechanischem Versagen führen können, besonders wenn keine vollständig durchoxidierte Schicht vorliegt (Spritzer in Schicht). Das Oxidationsverhalten wurde nun bei höheren Auslagerungstemperaturen untersucht, um sowohl Oxidations- und Diffusionsprozesse zu beschleunigen.

### 3. Beispiel: Oxidation einer Inconel Oberfläche

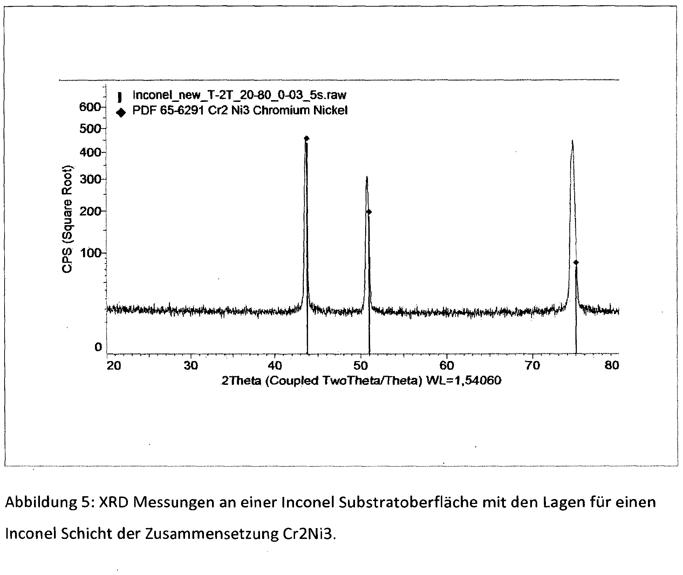

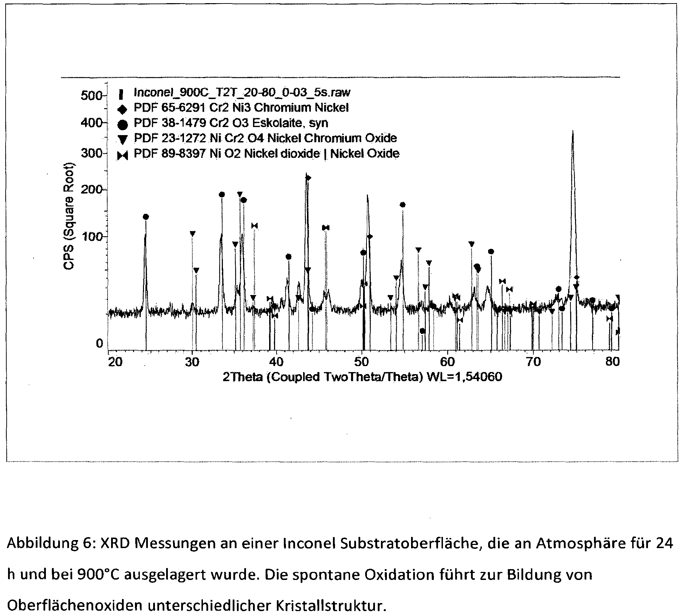

Es wurde ein Substrat aus Inconel für die Auslagerungsversuche gewählt. Dieses Material ist als Hochtemperaturlegierung bekannt und besteht im Wesentlichen aus Ni und Cr, wobei die Zusammensetzung bezüglich Ni und Cr variieren kann und zudem noch weitere Legierungselemente zugesetzt werden können. Abb. 5 zeigt das XRD Spektrum dieser Inconellegierung. Neben dem gemessenen XRD Spektrum, sind noch die Lagen der Bragg Reflexe für eine Ni0.6Cr0.2 Verbindung eingezeichnet, die in der Datenbank (PDF-2, International Centre for Diffraction Data, 12 Campus Boulevard, Newtown Square, PA 19073) unter Referenz PDF 65-6291 für eine Cr2Ni3 Verbindung zu finden sind. Man erkennt eine kleine Verschiebung in den Winkeln, was damit zu erklären ist, dass die hier gemessene Inconellegierung sich bezüglich der Referenz um einige wenige Prozent in der Zusammensetzung unterscheidet. Dieser Umstand ist aber ohne Bedeutung für die weiteren Erklärungen oder Untersuchungen. Ausser den Bragg Reflexen für Inconel, sieht man keine zusätzlichen Peaks. Anschliessend wurde dieses Substrat in einem Ofen bei 900°C unter Atmosphäre für 24 h ausgelagert. Nach dieser Auslagerung wurde wieder eine XRD Messung der Substratoberfläche durchgeführt. Diese ist in Abb. 6 wiedergegeben. Das XRD Spektrum unterscheidet sich deutlich von dem in Abb. 5. Neben den Inconel Peaks (Cr2Ni3, PDF 65-6291) beobachtet man noch weitere Reflexe, die verschiedenen Oxidphasen zugeordnet werden können, welche sich spontan bei der Auslagerung gebildet habe. Deutlich sieht man die Bildung der Eskolaite Phase des Cr203 (PDF 38-1479) und der NiCr2O4 Phase (PDF 23-1272) sowie des NiO2 (PDF 89-8397). Die Messungen belegen deutlich, dass sich an der Oberfläche des Inconel verschiedene Oxidphasen bilden, als die erwartete spontan ablaufende selektive Oxidation der metallischen Komponenten. Diese Oxidphasen sind zwangsweise mit einer Erosion der Oberfläche des Substratmaterials verbunden, da sie mit verschiedenen Dichten und verschieden schnell wachsen.

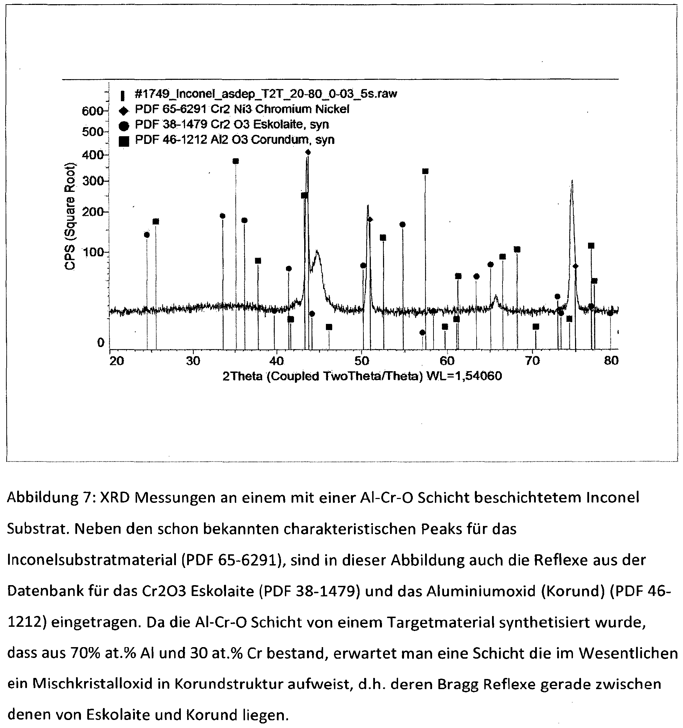

In weiteren Experimenten soll nun die vorteilhafte Wirkung der erfindungsgemässen Schicht untersucht werden, die auch die Nachteile bei den "artverwandten" Oxiden vermeidet. Dazu wurde eine ca. 2 µm dicke Al-Cr-O Schicht auf dem Inconelsubstrat abgeschieden. Als Anpassung an das Substrat wurde eine dünne Cr-haltige Schicht ausgesucht, wobei auch andere Interfaces gewählt werden können. Die beschichtete Oberfläche wurde wieder mittels XRD untersucht. In Abb. 7 ist diese Messung angegeben. Neben den schon bekannten charakteristischen Peaks für das Inconelsubstratmaterial (PDF 65-6291), sind in dieser Abbildung auch die Reflexe aus der Datenbank für das Cr2O3 Eskolaite (PDF 38-1479) und das Aluminiumoxid (Korund) (PDF 46-1212) eingetragen. Da die Al-Cr-O Schicht von einem Targetmaterial synthetisiert wurde, dass aus 70% at.% Al und 30 at.% Cr bestand, erwartet man eine Schicht die im Wesentlichen ein Mischkristalloxid in Korundstruktur aufweist, d.h. deren Bragg Reflexe gerade zwischen denen von Eskolaite und Korund liegen. An mindestens drei Positionen kann man dieses beobachten: 2Theta etwa gleich 42.5°, 45° und 65.5°. Diese Peaks sind verbreitert, was auf kleine Kristallitgrösse hinweist. Mit verfahrensparametern lässt sich das beeinflussen.

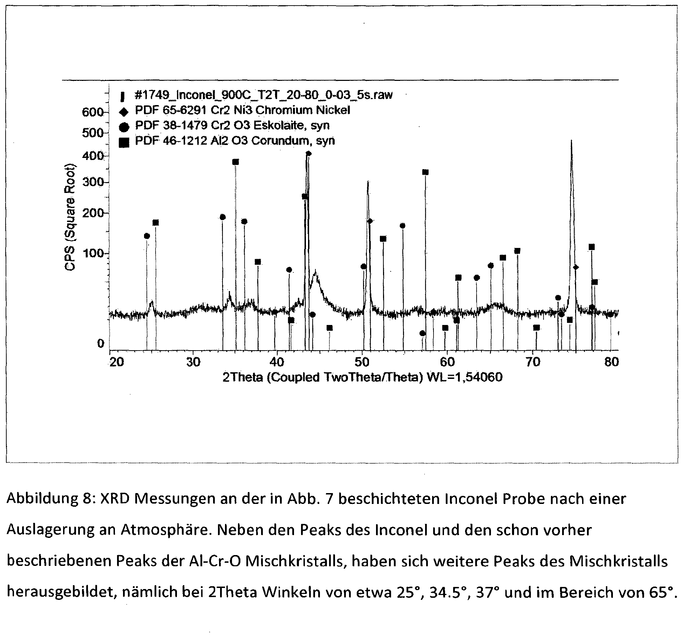

Dieses beschichtete Inconelsubstrat wurde wiederum für 24 h bei 900°C im Ofen unter Atmosphäre ausgelagert. Die XRD Analysen von dieser Schicht angefertigt nach der Auslagerung sind in Abb. 8 wiedergegeben. Neben den Peaks des Inconel und den schon vorher beschriebenen Peaks der Al-Cr-O Mischkristalls, haben sich weitere Peaks des Mischkristalls herausgebildet, nämlich bei 2Theta Winkeln von etwa 25°, 34.5°, 37° und im Bereich von 65°. Das weist auf eine grössere Kristallitgrösse hin, die durch die hohe Auslagerungstemperatur gefördert wurde. Es ist aber keine Änderung in der Kristallstruktur zu erkennen. Ebenso ist keine Andeutung von Oxidphasen zu erkennen, die sich im unbeschichteten Zustand auf dem Inconel während der Auslagerung gebildet hatten. Somit kann man folgendes feststellen:
- Die Al-Cr-O Schicht mit im wesentlichen Korundstruktur, also einphasiger Kristallstruktur, schützt Inconel vor einer spontanen und damit selektiven Oxidation der zwei metallischen Komponeneten Al und Cr.
- Dieses Verhalten zeigt auch, dass Al-Cr-O in vorwiegend Mischkristallstruktur eine ausgezeichnete Diffusionsbarriere für Sauerstoff ist.
- Die Al-Cr-O Schicht bleibt einphasig auch beim Aufheizen bis zu 900°C. Es kommt lediglich zu einer Vergrösserung der Kristallitgrösse.

Dieses Beispiel ist typisch für die Oxidbarrierewirkung des Al-Cr-O in Mischkristallstruktur. Diese Schutzwirkung besteht für alle eingangs erwähnten Legierungen und intermetallischen Verbindungen und wurde sowohl für den Schutz der Oberflächen von Vollmaterial nachgewiesen wie auch für Legierungen und intermetallische Verbindungen, die als Schichten synthetisiert wurden. Der ausgezeichnete Schutz ist gewährleistet für Al/Cr Verhältnisse, die bei der Synthese einer Oxidschicht zu der Mischkristallstruktur führen. Das trifft für den Bereich von etwa kleiner oder gleich 70 at.% Al Anteil zu, also für Al/Cr Verhältnisse ≤ 2.3 zu. Dieser Bereich kann durch Anpassung bestimmter Parameter des Beschichtungsverfahrens bis zu etwa 80 at.% Al Anteil ausgeweitet werden. Für den Bereich des höheren Al-Gehaltes besteht die synthetisierte Oxidschichtschicht zumindest teilweise aus einer Aluminiumoxidphase und Chromoxidphase, ist also mindestens zweiphasig. Da der Anteil des Al aber sehr hoch ist, kann es trotzdem zu einem guten Oberflächenoxid durch selektive Oxidation kommen, aber eben mit den Nachteilen die schon weiter oben für die Mehrphasigkeit bei der Oxidbildung diskutiert wurden. Auch an der Oberfläche der Mischkristallstruktur kann es dazu kommen, dass sich eine dünne Oxidschicht in Korundstruktur mit hohem oder ausschliesslich Al Anteil ausbildet. Dies schwächt aber das Materialsystem nicht, da sich ein solches Aluminiumoxid bei den hohen Formierungstemperaturen ebenfalls in Korundstruktur bildet und damit kompatibel mit der Al-Cr-O Unterlage ist.

### 5. Beispiel: Oxidationsverhalten der Spritzer

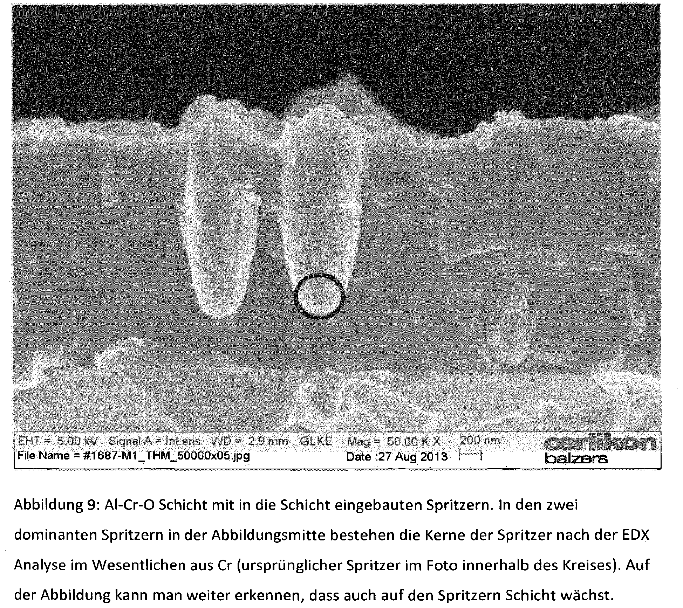

Al-Cr-O ist, falls es als Mischkristall in Korundstruktur abgeschieden wird, bezüglich seiner Kristallstruktur sehr stabil ist. Trotzdem ist es verwunderlich, dass die Barrierewirkung für Sauerstoff so gut ist. Wie eingangs schon erwähnt, wurden die Schichten mittels reaktiver kathodischer Funkenverdampfung hergestellt. Ein Merkmal dieser Beschichtungstechnologie sind die bei der Verdampfung entstehenden Spritzer, die teilweise in die abgeschiedene Schicht eingebaut werden. Die Spritzerbildung wird noch gefördert, wenn man die Al-Cr-O Schicht nicht mit einelementigen Targets herstellt, also unter Benutzung von elementaren Al und Cr Targets, sondern Targets verwendet, die die beiden Elemente enthalten, also beispielsweise Al-Cr Targets mit einem Verhältnis von 70 at.% Al und 30 at.% Cr. Das können entweder pulvermetallurgisch oder schmelzmetallurgisch hergestellte Targets sein, d.h. die Elemente müssen in diesen Targets nicht unbedingt elementar vorliegen, sondern können auch in intermetallischen Verbindungen oder Lösungen vorliegen. Die Analyse an den Schichten, die so mittels reaktiver kathodischer Funkenverdampfung synthetisiert werden, zeigen deshalb im Allgemeinen neben der eigentlichen Al-Cr-O Schicht noch Spritzer, die in die Schicht eingebaut wurden (Abb. 9). Der "Kern" der Spritzer besteht vorwiegend aus Cr oder vorwiegend AI. Die Spritzerkerne besitzen metallischen Charakter und sind wegen ihrer Grösse nicht durchoxidiert. In den zwei dominanten Spritzern in der Abbildungsmitte bestehen die Kerne der Spritzer nach der EDX Analyse im Wesentlichen aus Cr (ursprünglicher Spritzer im Foto innerhalb des Kreises). Auf dem SEM Bruchquerschnitt sieht man weiter, dass diese Spritzer in die etwa 2.2 µm dicke Al-Cr-O Schicht eingebaut werden, die auf einem Hartmetallsubstrat abgeschieden wurde. Die Al-Cr-O Schicht weist bis auf die Spritzer im Wesentlichen dieselbe chemische Zusammensetzung bezüglich der metallischen Bestandteile auf, wie sie im Target vorliegen. Auf der Abbildung kann man weiter erkennen, dass auch auf den Spritzern Schicht wächst. Man sieht aber auch, dass sich zwischen Schicht und Spritzer trotz des Schichtwachstums deutliche Grenzen abzeichnen, an denen eine Diffusion stattfinden könnte. Die nicht durchoxidierten Spritzer könnten deshalb ein Problem sein, falls man eine dichte Barriereschicht für Sauerstoff herstellen möchte. Da die Experimente aber gerade zeigten, dass die Al-Cr-O Schichten vortreffliche Barriereeigenschaften aufweisen, wurde nach einer Erklärung für dieses Verhalten gesucht.

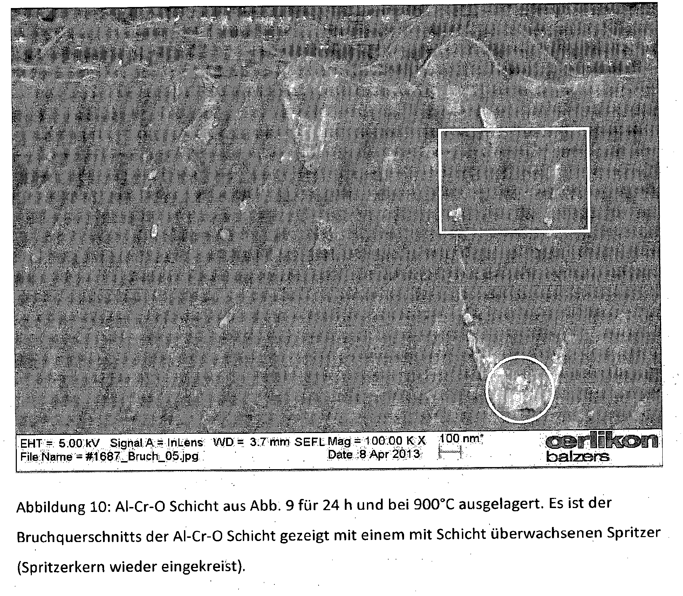

Dazu wurde die Al-Cr-O Schicht aus Abb. 9 für 24 h und bei 900°C ausgelagert. Anschliessend wurde wieder der Bruchquerschnitt im Rasterelektronenmikroskop betrachtet. In Abb. 10 ist die Aufnahme des Bruchquerschnitts der Al-Cr-O Schicht gezeigt. In der Abbildung wurde ein mit Schicht überwachsener Spritzer (Spritzerkern wieder eingekreist) stark vergrössert. Nach dem Auslagern sind die Grenzen zwischen Spritzer und Schicht zumindest im oberen Teil verschwunden, d.h. es kommt zu einer innigen Anbindung zwischen der Al-Cr-O Schicht und den Teil der Schicht, die den Spritzer überwächst. Erinnert man sich der Abb. 1, auf der man im ungeschützten Bereich die Volumenvergrösserung des Stahls durch die spontane Oxidation desselben beobachtete, und wendet man dieses auch auf die Oxidation von Spritzern oder schichtüberwachsenen Spritzern im Al-Cr Materialbereich an, so kann man den Mechanismus des sich selbst Versiegeln der Spritzer nachvollziehen. Falls also Grenzen durchlässig sind für eine Sauerstoffdiffusion, so schliessen sich diese mit der Volumenvergrösserung beim Oxidwachstum. Der grosse und offensichtlich wichtige Unterschied zu dem gewöhnlichen Oxidwachstum auf anderen Materialsystemen ist der, dass die spontan aufwachsende Oxidschicht sich als Mischkristall in Korundstruktur bildet oder in den Grenzfällen des reinen Metalls sich ebenfalls in der Korundstruktur ausbildet.

Damit lässt sich die Schlussfolgerung ziehen, dass an metallischen Spritzern, die sich in einer temperaturstabilen (bezüglich Kristallstruktur) Oxidmischkristallstruktur befinden und die bei spontaner Oxidation selbst eine Kristallstruktur des Oxids ausbilden, die die gleiche Kristallstruktur der Mischkristallstruktur hat, man den Selbsversiegelungsmechanismus beobachten kann der zu ausgezeichneten Barriereigenschaften für Sauerstoffdiffusion beiträgt.

Konkret offenbart die vorliegende Erfindung ein Verfahren zur Herstellung einer Oxidationsbarrierenschicht auf einem Werkstücksubstrat wobei die Oxidationsbarrierenschicht mittels physikalischer Abscheidung aus der Gasphase (PVD) hergestellt wird und ein Oxid ist welches mit der unbeschichteten Oberfläche des Werkstückes materialverwandt ist.

Vorzugsweise ist das PVD Verfahren ein kathodisches Arcverdampfungsverfahren.

Vorzugsweise ist das Verfahren dergestalt durchgeführt, dass die Oxidationsbarierrenschicht eine Al-Cr-O Schicht umfasst.

Das gemäss der vorliegenden Erfindung verwendete PVD Verfahren zur Herstellung der Oxidationsbarrierenschicht kann ein kathodisches Arcverdampfungsverfahren, das dergestalt durchgeführt wird, dass die abgeschiedene Oxidationsbarrierenschicht Spritzer umfasst.

Ein Verfahren gemäss der vorliegenden Erfindung kann auch einen Schritt umfassen, bei dem die synthetisierten Oxidschichten einer Nachoxidation im Plasma oder einer sonstigen Nachoxidation unterzogen werden.

Gleichzeitig offenbart die vorliegende Erfindung ein Werkstücksubstrat mit einer mittels PVD hergestellten Oxidationsbarrierenschicht, wobei die Oxidationsbarrierenschicht ein Oxid ist welches mit der unbeschichteten Oberfläche des Werkstückes materialverwandt ist. Gemäss bevorzugten Ausführungsformen der vorliegenden Erfindung kann diese Oxidschicht, wie oben bereits erwähnt, Spritzer und/oder zumindest ein Al-Cr-O Schicht umfassen.

## Patentansprüche

1. Verfahren zur Herstellung einer Oxidationsbarrierenschicht auf einem Werkstücksubstrat, wobei die Oxidationsbarrierenschicht mittels physikalischer Abscheidung aus der Gasphase (PVD) hergestellt wird und ein Oxid ist, welches mit der unbeschichteten Oberfläche des Werkstückes materialverwandt ist, indem es die gleichen metallischen Komponenten aufweist wie die unbeschichtete Oberfläche des Werkstücksubstrats, wobei die Oxidschicht spontan aufwächst und sich als Mischkristall in Korundstruktur bildet, wobei die Oxidationsbarrierenschicht eine sich bezüglich der Sauerstoffdiffusion selbst schließende Schicht ist.

2. Verfahren nach Anspruch 1, **dadurch gekennzeichnet, dass** das PVD Verfahren ein kathodisches Arcverdampfungsverfahren ist.

3. Verfahren zur Herstellung einer Oxidationsbarrierenschicht auf einem Werkstücksubstrat, wobei die Oxidationsbarrierenschicht mittels physikalischer Abscheidung aus der Gasphase (PVD) hergestellt wird und die Oxidationsbarierrenschicht eine AI-Cr-0 Schicht umfasst.

4. Verfahren nach Anspruch 3, **dadurch gekennzeichnet, dass** das PVD Verfahren ein kathodisches Arcverdampfungsverfahren ist und die Oxidationsbarrierenschicht Spritzer umfasst.

5. Verfahren nach einem der vorangehenden Ansprüche, **dadurch gekennzeichnet, dass** die synthetisierten Oxidschichten einer Nachoxidation im Plasma oder einer sonstigen Nachoxidation unterzogen werden.

6. Werkstücksubstrat mit einer mittels PVD hergestellten Oxidationsbarrierenschicht, **dadurch gekennzeichnet, dass** die Oxidationsbarrierenschicht ein Oxid ist, welches mit der unbeschichteten Oberfläche des Werkstückes materialverwandt ist, indem es die gleichen metallischen Komponenten aufweist wie die unbeschichtete Oberfläche des Werkstücksubstrats, wobei die Oxidschicht spontan aufwächst und sich als Mischkristall in Korundstruktur bildet, wobei die Oxidationsbarrierenschicht eine sich bezüglich der Sauerstoffdiffusion selbst schließende Schicht ist.

## Claims

1. A method for producing an oxidation barrier layer on a workpiece substrate, wherein the oxidation barrier layer is produced using a physical deposition method from the gas phase (PVD) and the oxidation barrier layer is an oxide that is materially related to the uncoated surface of the workpiece by comprising the same metallic components that are also found in the uncoated surface of the workpiece substrate, wherein the oxide layer grows spontaneously and forms as a solid solution in a corundum structure, wherein the oxidation barrier layer is a self-sealing layer with regard to oxygen diffusion.

2. The method according to claim 1, **characterized in that** the PVD method is a cathodic arc deposition method.

3. The method for producing an oxidation barrier layer on a workpiece substrate, wherein the oxidation barrier layer is produced using a physical deposition method from the gas phase (PVD) and the oxidation barrier layer includes an Al-Cr-O layer.

4. The method according to claim 3, **characterized in that** the PVD method is a cathodic arc deposition method and the oxidation barrier layer comprises splashes.

5. The method according to one of the preceding claims, **characterized in that** the synthesized oxide layers are subject to a post-oxidation in plasma or another post-oxidation.

6. A workpiece substrate with an oxidation barrier layer produced by PVD, **characterized in that** the oxidation barrier layer is an oxide that is materially related to the uncoated surface of the workpiece by comprising the same metallic components that are also found in the uncoated surface of the workpiece substrate, wherein the oxide layer grows spontaneously and forms as a solid solution in a corundum structure, wherein the oxidation barrier layer is a self-sealing layer with regard to oxygen diffusion.

## Revendications

1. Procédé de production d'une couche barrière à l'oxydation sur le substrat d'une pièce à usiner, la couche barrière à l'oxydation étant produite au moyen d'un dépôt physique en phase vapeur (PVD) et la couche barrière à l'oxydation étant un oxyde qui est, du point de vue du matériel, apparenté à la surface non revêtue de la pièce à usiner parce qu'il comprend les même composants métalliques que la surface non revêtue du substrat de la pièce à usiner, la couche d'oxyde croissant spontanément et se formant sous forme d'une solution solide dans une structure de corindon, la couche barrière à l'oxydation étant une couche qui se scelle elle-même par rapport à la diffusion d'oxygène.

2. Le procédé selon la revendication 1, **caractérisé en ce que** le procédé PVD est un procédé d'évaporation par arc cathodique.

3. Procédé de production d'une couche barrière à l'oxydation sur le substrat d'une pièce à usiner, la couche barrière à l'oxydation étant produite au moyen d'un dépôt physique en phase vapeur (PVD) et la couche barrière à l'oxydation comprenant une couche Al-Cr-O.

4. Le procédé selon la revendication 3, **caractérisé en ce que** le procédé PVD est un procédé d'évaporation par arc cathodique et la couche barrière à l'oxydation comprend des éclaboussures.

5. Le procédé selon l'une quelconque des revendications précédentes, **caractérisé en ce que** les couches d'oxyde synthétisées sont soumises à une post-oxydation dans le plasma ou à une autre post-oxydation.

6. Substrat d'une pièce à usiner ayant une couche barrière à l'oxydation produite au moyen d'un procédé PVD, **caractérisé en ce que** la couche barrière à l'oxydation est un oxyde qui est, du point de vue du matériel, apparenté à la surface non revêtue de la pièce à usiner parce qu'il comprend les même composants métalliques que la surface non revêtue du substrat de la pièce à usiner, la couche d'oxyde croissant spontanément et se formant sous forme d'une solution solide dans une structure de corindon, la couche barrière à l'oxydation étant une couche qui se scelle elle-même par rapport à la diffusion d'oxygène.
